Europäisches Patentamt

European Patent Office

Office européen des brevets

(19)

(11) Veröffentlichungsnummer: **0 178 565**
**A1**

(12) # EUROPÄISCHE PATENTANMELDUNG

(21) Anmeldenummer: 85112686.2

(22) Anmeldetag: 07.10.85

(51) Int. Cl.⁴: **H01L 21/66** , B23K 20/10

(30) Priorität: 10.10.84 DE 3437207

(43) Veröffentlichungstag der Anmeldung:
23.04.86 Patentblatt 86/17

(84) Benannte Vertragsstaaten:
AT BE CH DE FR GB IT LI LU NL SE

(71) Anmelder: **Siemens Aktiengesellschaft**
**Berlin und München Wittelsbacherplatz 2**
**D-8000 München 2(DE)**

(72) Erfinder: **Seitz, Max Gerhard, Dipl.-Ing.**
**Autharistrasse 38**
**D-8000 München 90(DE)**
Erfinder: **Röser, Klaus, Dr. rer. nat.**
**Bussardstrasse 15a**
**D-8011 Neukeferloh(DE)**
Erfinder: **von Raben, Ulrich, Ph. D.**
**Hofbrunnstrasse 80**
**D-8000 München 71(DE)**

(54) **Überwachung von Bondvorgängen durch Schallemissionsanalyse.**

(57) Die beim Bonden auftretenden Schallwellen werden durch einen geeigneten Schallaufnehmer, der möglichst nahe am Bondkopf oder am Heiztisch befestigt ist, registriert und über geeignete Verstärker einem Auswertegerät zugeführt. Im Auswertegerät wird die aufgenommene Schallemission mit einem zuvor ermittelten Wert verglichen, der für optimale Bedingungen des Bauelementes, Bonddrahtes und Maschineneinstellung zu erwarten ist. Durch Vergleich der Werte kann gegebenenfalls eine Nachregelung der Maschinenparameter durchgeführt werden.

EP 0 178 565 A1

Überwachung von Bondvorgängen durch Schallemissionsanalyse.

Die Erfindung betrifft ein Verfahren zur vorzugsweise automatischen Überwachung der Verbindungsstellen bei Bondvorgängen. Unter Bondvorgängen sollen zum Beispiel Ball-und Wedge-Verbindungen sowie auch Lötverbindungen verstanden werden.

Bei der Herstellung integrierter Halbleiterbauelemente wird die elektrische Verbindung des Bauelementes zum Trägerkörper durch Anbringung von Metalldrähten geringen Durchmessers (zum Beispiel 17 bis 50 μm) ausgeführt. Hierzu stehen mehrere Verfahren (Bondverfahren) zur Verfügung, wie Thermokompressions-, Thermosonic- und Ultrasonicverfahren. Die Qualitätsüberwachung der Verbindungsstellen (Bondstellen zwischen Draht und Bauelement bzw. Draht und Träger) wird während und nach der Herstellung visuell vorgenommen. Dies geschieht durch direkte Beobachtung durch ein Mikroskop oder Darstellung des vergrößerten Abbildes auf einem Fernsehmonitor. Einzelne gezielte Kontrollen der fertigen Bauelemente werden mittels standardisierten, meist zur Zerstörung des Bauelementes führenden Tests (zum Beispiel Zug- bzw. Scherversuche) durchgeführt.

Die Herstellung der Verbindung zwischen Halbleiterbauelement und Träger durch eine Bondmaschine geschieht dadurch, daß ein Draht bestimmter Dicke für kurze Zeit (ca. 1 sec) durch den Bondkopf auf die zu verbindende Stelle des erwärmten Bauelementes gedrückt wird. Während dieser Andrückphase werden Schallwellen im Frequenzgebiet 50 kHz bis 1 MHz emittiert, die ihren Ursprung in verschiedenen physikalischen Ursachen haben (zum Beispiel Verformung der Drahtspitze von Kugel zum Nagelkopf, Fließen des Drahtes auf dem metallisierten Untergrund).

Es ist bereits bekannt, die Schallemission als Prüfverfahren zu benutzen. Dies geschieht aber grundsätzlich erst zur Prüfung der fertigen Verbindung, siehe zum Beispiel den Aufsatz von G. G. Harman in IEEE Transactions on Parts, Hybrids, and Packaging, Vol. PHP-13, No. 2, June 1977. Dieses Verfahren stellt den Fehler erst nach Abschluß des Bondvorganges fest, so daß fehlerhafte Verbindungen nur noch ausgechieden werden können oder nachbearbeitet werden müssen.

Der Erfindung liegt die Aufgabe zugrunde, ein Verfahren und eine Anordnung zur Überwachung von Bondvorgängen zu schaffen, mit dem der Bondvorgang auch automatisch überwacht werden kann. Diese Aufgabe wird dadurch gelöst, daß die während der Andrückphase emittierten Schallwellen durch einen Schallaufnehmer registriert und über Verstärker einem Auswertegerät zum Vergleich mit Richtwerten und zur Überwachung und eventueller Nachregelung der Maschinenparameter zugeführt werden. Der Vorteil der Erfindung besteht darin, daß dadurch nicht nur ein zusätzlicher Arbeitsvorgang, nämlich der der visuellen Kontrolle, eingespart werden kann, sondern daß es auch möglich ist, die Kontrolle des Bondvorganges zu automatisieren und die wichtigsten Maschinenparameter überwacht und geregelt werden können. Vorteilhaft gegenüber dem Stand der Technik ist ferner, daß bereits während des Bondvorganges geprüft, und falls notwendig nachgeregelt werden kann. Auf diese Weise wird eine 100 %ige Prüfung sämtlicher Bondverbindungen erreicht. Somit ist ein anschließender Prüfvorgang nicht mehr erforderlich.

Eine Anordnung zur Durchführung des Verfahrens ist Gegen stand der Ansprüche 2 und 3.

Die Erfindung wird anhand einer schematischen Darstellung einer Vorrichtung zur Schallemissionsanalyse beim Bonden von Halbleiterbauelementen erläutert:

Mit 1 ist ein Träger bezeichnet, der auf einem nicht dargestellten Heiztisch angeordnet ist. Auf diesem Träger liegt ein Chip 2 zum Bonden bereit. Über dem Chip befindet sich ein Bondkopf 3 mit einer Heizung 4. Der Bondkopf ist in vertikaler Richtung bewegbar. 5 ist ein Bonddraht und 6 ein Sensor, der auch direkt im Bondkopf integriert sein kann. Signale, die vom Sensor aufgenommen werden, gelangen zu einer Auswerteeinheit 7, an deren Ausgang eine Regelung 8 für die Bondmaschine angeschlossen ist.

Die beim Bondvorgang auftretenden Schallwellen werden durch einen Schallaufnehmer in Form eines Sensors oder Wandlers 6, der möglichst nahe am Bondkopf 3 oder am Heiztisch befestigt ist, registriert und über geeignete, nicht dargestellte Verstärker dem Auswertegerät 7 (Computer) zugeführt. Es ist möglich, einen speziellen Bondkopf zu benützen, in dem der Schallaufnehmer schon fest integriert ist. Im Auswertegerät 7 wird die aufgenommene Schallemission mit einem zuvor ermittelten Wert (Richtwert) verglichen, der für optimale Bedingungen des Bauelementes (Bonddrahtes) und Maschineneinstellungen zu erwarten ist. Durch Vergleich dieser beiden Werte (aufgenommene Schallemission und Richtwert) kann die Qualität der Verbindung festgestellt und damit eine Nachregelung der Maschinenparameter (Heiztemperatur, Andrückzeit, Druck und eventuell Ultraschallenergie) durchgeführt werden.

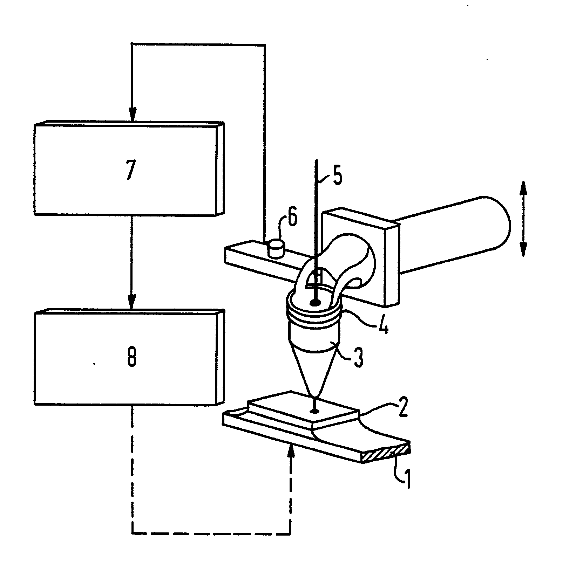

**Ansprüche**

1. Verfahren zur vorzugsweise automatischen Überwachung der Verbindungsstellen bei Bondvorgängen, **dadurch gekennzeichnet,** daß die während der Anrückphase emittierten Schallwellen durch einen Schallaufnehmer (6) registriert und über Verstärker einem Auswertegerät (7) zum Vergleich mit Richtwerten und Überwachung und eventueller Nachregelung (8) der Maschinenparameter zugeführt werden.

2. Anordung zur Durchführung des Verfahrens nach Anspruch 1, **dadurch gekennzeichnet,** daß als Schallaufnehmer (6) ein Sensor oder Wandler dient, der möglichst nahe am Bondkopf (3) oder am Heiztisch befestigt ist.

3. Anordnung nach Anspruch 2, **dadurch gekennzeichnet,** daß ein Bondkopf (3) Verwendung findet, in dem der Schallaufnehmer (6) fest integriert ist.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | US-A-3 857 279 (SALZER et al.) * Spalte 1, Zeile 21 - Spalte 2, Zeile 62; Figuren 1-6; Spalte 3, Zeilen 20-39; Spalte 4, Zeile 64 - Spalte 5, Zeile 33 * | 1-3 | H 01 L 21/66 B 23 K 20/10 |
| X | US-A-3 890 831 (CUSICK et al.) * Figuren 1,2; Spalte 1, Zeilen 31-50; Spalte 2, Zeile 62 - Spalte 3, Zeile 12 * | 1-3 | |
| A | DE-A-2 741 224 (SIEMENS) * Figuren 1-4; Seite 3, Zeile 19 - Seite 5, Zeile 5; Seite 5, Zeile 18 - Seite 6, Zeile 24; Seite 7, Zeilen 26-32; Ansprüche * | 1,2 | |
| A | PATENTS ABSTRACTS OF JAPAN, Band 7, Nr. 8 (E-152) [1153], 13. Januar 1983, Seite 26 E-152; & JP - A - 57 166 042 (TOKYO SHIBAURA DENKI K.K.) 13.10.1982 * Insgesamt * | 1-3 | RECHERCHIERTE SACHGEBIETE (Int. Cl.4) H 01 L B 23 K |
| A | US-A-3 153 850 (WORLTON et al.) | | |
| A | US-A-4 040 885 (HIGHT et al.) | | |
| | --- -/- | | |

Der vorliegende Recherchenbericht wurde für alle Patentansprüche erstellt.

| Recherchenort | Abschlußdatum der Recherche | Prüfer |
|---|---|---|
| DEN HAAG | 10-01-1986 | IRVINE R.J. |

Europäisches
Patentamt

**EUROPÄISCHER RECHERCHENBERICHT**

Nummer der Anmeldung

EP 85 11 2686

Seite 2

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | US-A-4 255 851 (FORTUNA) | | |
| | --- | | |
| A | US-A-3 852 999 (WRIGHT) | | |
| | ----- | | |

RECHERCHIERTE SACHGEBIETE (Int. Cl.4)

Der vorliegende Recherchenbericht wurde für alle Patentansprüche erstellt.

| Recherchenort DEN HAAG | Abschlußdatum der Recherche 10-01-1986 | Prüfer IRVINE R.J. |
|---|---|---|

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503 03 82